# EUROPEAN PATENT APPLICATION

(11) **EP 3 640 666 A1**
(43) Date of publication of application: **22.04.2020**
(21) Application number: 19204089.7
(22) Date of filing: 18.10.2019
(51) Int. Cl.: G01S 7/00

(54) **1/F NOISE CANCELLATION IN PULSED UWB RADAR RADIO RECEIVER IC**

(30) Priority: 18.10.2018 US 201862747515 P; 16.10.2019 US 201916654991
(71) Applicant: Integrated Device Technology, Inc., San Jose CA 95138 (US)
(72) Inventor: GOWING, Jonathan, Santa Cruz, CA 95065 (US); MÜLLER, Urs, 8903 Birmensdorf (CH); LITTLE, James, Sacramento, CA 95818 (US)
(74) Representative: Lippert Stachow Patentanwälte Rechtsanwälte Partnerschaft mbB

(57) **Abstract**

A receiver according to some embodiments of a pulsed UWB receiver. The UWB receiver includes a down-conversion mixer coupled to the first switch and providing an IF signal; an integrator that receives the IF signal, the integrator being switched on and off at a periodic repetition frequency (PRF); a sample and hold circuit coupled to the integrator; a first phase switch that is switched at PRF/2 coupled to receive a signal before the integrator; a second phase switch coupled to the sample and hold circuit, the second switch also being switched at PRF/2; and a low-pass filter coupled to the second switch, wherein 1/f noise is filtered out by the low-pass filter.

## Description

Embodiments of the present invention are related to radar radio receivers and, in particular, to 1/f noise cancelation in pulsed ultra-wideband (UWB) radar radio receiver integrated circuits (ICs).

Pulsed ultra-wideband (UWB) radar has applications in many medical and industrial areas. Pulsed UWB radar can be used to image the interior of objects and therefore has application for through-wall detection of humans and other objects, for medical imaging characterization of internal organs or cancer, and industrial applications such as object location for autonomous vehicle applications or other such uses. Pulsed UWB radar, for example, can provide highly accurate information regarding the object, including its relative motion.

Doppler pulsed RF radar receiver systems down convert an RF signal to a mixer intermediate frequency (IF) that is very close to DC (<200Hz). Close to DC, there is significant 1/f noise present in all silicon devices. The desired signal and the noise occupy the same signal frequency spectrum. The RF mixer employed in the down conversion has the competing requirements of gain (or low IL), low noise at high frequency, high speed operation (>8GHz), and low frequency 1/f noise close to DC. These requirements cannot be simultaneously met. Additionally, the IF integrator and sample/hold in the system must have a very low 1/f noise contribution.

Therefore, there is a need to develop better methods of reducing 1/f noise in pulsed UWB radar detectors.

A receiver according to some embodiments of a pulsed UWB receiver. The UWB receiver includes a down-conversion mixer coupled to the first switch and providing an IF signal; an integrator that receives the IF signal, the integrator being switched on and off at a periodic repetition frequency (PRF); a sample and hold circuit coupled to the integrator; a first phase switch that is switched at PRF/2 coupled to receive a signal before the integrator; a second phase switch coupled to the sample and hold circuit, the second switch also being switched at PRF/2; and a low-pass filter coupled to the second switch, wherein 1/f noise is filtered out by the low-pass filter.

A method of operating a pulsed ultra-wide band (UWB) receiver includes receiving a pulsed RF signal; down converting the RF to an intermediate frequency (IF) signal in an RF mixer, the IF signal being close to DC; integrating the IF signal in an integrator, the integrator being switched on and off at a periodic repetition frequency (PRF); sampling the integrated IF signal in a sample and hold circuit coupled to the integrator; chopping signals with a first phase switch that is switched at PRF/2 coupled to receive a signal before the integrator and a second phase switch coupled to the sample and hold circuit, the second switch also being switched at PRF/2; and removing the 1/f noise with a low-pass filter coupled to the second switch.

These and other embodiments are discussed below with respect to the following figures.
Figures 1A and 1B illustrate an example of a pulsed UWB radar system.
Figure 2 illustrates conventional chopping to remove the 1/f noise.
Figures 3A, 3B, and 3C illustrates an example layout of a receiver according to some embodiments of the present invention.
Figures 4A and 4B further illustrate a conventional receiver system as illustrated in Figure 1B.
Figure 5A and 5B further illustrate a receiver according to some embodiments of the present invention.
Figure 5C illustrates further functionality of the receiver illustrated in Figures 5A and 5B.
Figure 6 illustrates the timing of the phase inversion signals in the receiver illustrated in Figures 5A, 5B, and 5C.
Figure 7 illustrates an idealized noise up-conversion circuit to PRF/2 with the phase shifting circuits surrounding the integrator and S/H circuitry.
Figure 8 illustrates the resulting idealized noise that has been upconverted to PRF/2 compared to the original linear noise for the system illustrated in Figure 7.
Figure 9 illustrates idealized noise up periodic AC (PAC) voltage gain input to output in the system illustrated in Figure 7.
Figure 10 illustrates idealized switching circuits implemented around IF circuitry, integrator and S/H.
Figure 11 illustrates timing in the idealized switching circuits surrounding the integrator and S/H circuitry as illustrated in Figure 10.
Figure 12 illustrates output noise of the sample and hold circuitry with idealized switching circuits around integrator and S/H circuits as illustrated in Figure 10.
Figure 13 illustrates the output noise of the sample and hold circuits.
Figure 14 illustrates small signal PAC Vgain input to output.
Figure 15 illustrates output noise of the sample and hold circuit.
Figure 16 illustrates the output noise from various sources.

These and other aspects of embodiments of the present invention are further discussed below.

In the following description, specific details are set forth describing some embodiments of the present invention. It will be apparent, however, to one skilled in the art that some embodiments may be practiced without some or all of these specific details. The specific embodiments disclosed herein are meant to be illustrative but not limiting. One skilled in the art may realize other elements that, although not specifically described here, are within the scope and the spirit of this disclosure.

This description illustrates inventive aspects and embodiments should not be taken as limitingthe claims define the protected invention. Various changes may be made without departing from the spirit and scope of this description and the claims. In some instances, well-known structures and techniques have not been shown or described in detail in order not to obscure the invention.

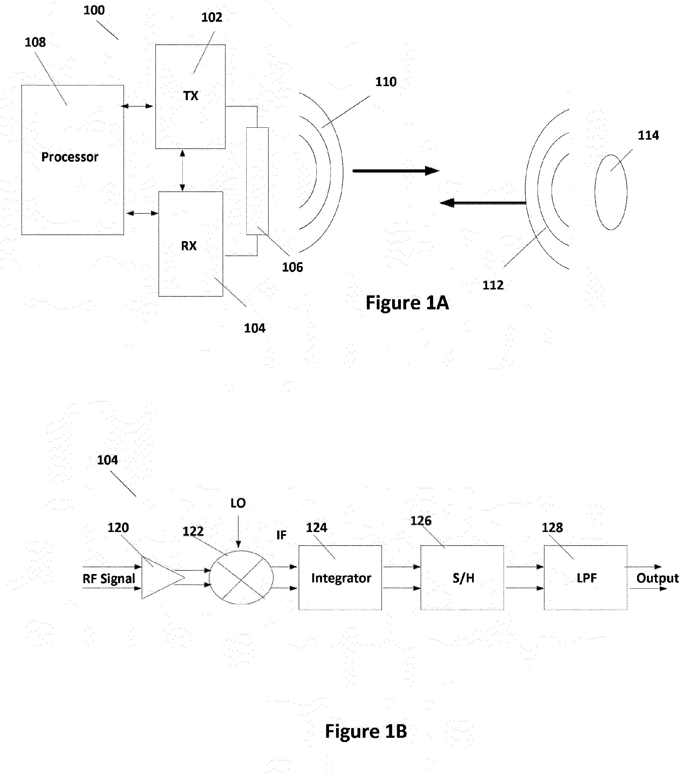

Figures 1A and 1B illustrate a block diagram of a pulsed UWB radar system. As is illustrated in Figure 1A, system 100 includes transmitter 102 coupled to an antenna to provide a pulse 110.

Pulse 110 is reflected from an object 114, resulting in a return pulse 112. Return pulse 112 is received by antenna 106 and the RF signal is provided to receiver 104. Transmitter 102 and receiver 104 are coupled to a processor 108, which provides control signals to transmitter 102 and receiver 104 as well as digitally analyzing signals received from receiver 104. In particular, transmitter 102 generates a pulse. At some later time, receiver 104 is activated to receive the return pulse 112. In most systems, receiver 104 is not active during pulse generation in transmitter 102.

Figure 1B illustrates signal processing in receiver 104. As illustrated in Figure 1B, the RF signal received from antenna 106 is input to a low-noise amplifier 120, which may also include a Balun. The output signal from amplifier 120 is input to RF mixer 122 where it is downconverted to an intermediate frequency IF that is close to DC. The IF frequency signal is then input to a sample and hold 126 and then to a low-pass filter 128 to provide an output signal.

In accordance with some embodiments of the present invention, 1/f noise is reduced in a pulsed ultra-wideband receiver by introducing a first 180 degree phase shift prior to integrator 124 and a second 180 degree phase shift after S/H 124. The phase shifts are shifted according to the periodic repetition frequency (PRF). The pulsed doppler radar system has a periodic Repetition Frequency (PRF) that is used to turn the receiver on and off. This signal can be used as a frequency input to invert the signal path of the mixer and the IF integrator 124 and sample/hold 126 every PRF event. This effectively mixes up the 1/f noise close to DC to the PRF frequency, reducing the noise at low frequencies. The phase shifts occur in front of the down conversion RF mixer 122 and after the integrator 124. This chopping is possible because the receiver is not always on. We can invert the signal path twice during the off period and no switching event is amplified. No phase synchronization of the RF switching circuit and the IF circuit are needed, provided they have both settled at the times the receiver is on.

Conventionally, 1/f cancelation (chopping) is typically used in low frequency instrumentation amplifiers. The IF frequencies and required noise levels of the mixer IF output (at sensitivity) are comparable to an instrumentation amplifier. Instrumentation amplifiers typically process very low amplitude signals, at low frequencies (e.g. in the low Hz range). In low noise instrumentation linear opamps, chopping circuits are typically implemented to improve input voltage offsets. Chopping circuits also reduce low frequency 1/f noise by up converting the noise out of band and then low pass filtering. In some cases, these types of circuits can be leveraged to mitigate the 1/f noise generated at the mixer IF output.

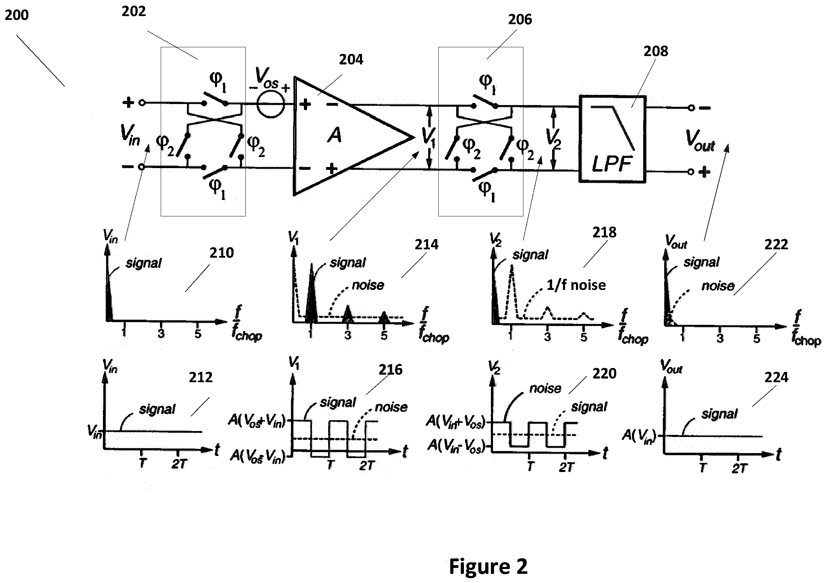

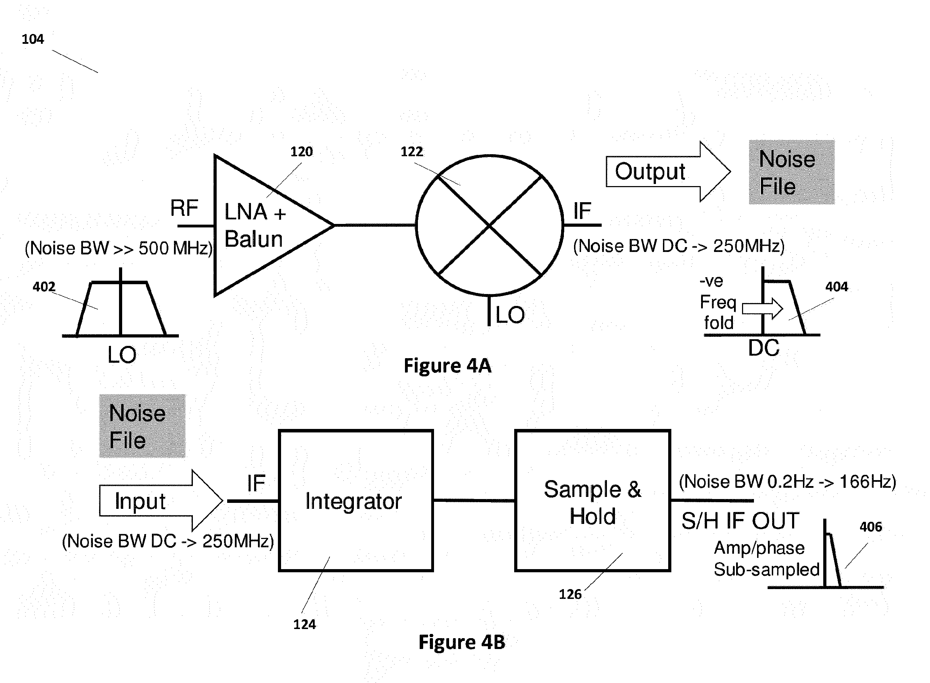

Figure 2 illustrates an example of a conventional linear CW chopper amplifier 200 as described in Andre Bakker, Karen Thiele, and J.H. Huijsing, "A CMOS Nested-Chopper Instrumentation Amplifier with 100-nV Offset," 2000 IEEE International Solid-State Circuits Conference, Digest of Technical Papers (Cat. No. 00CH37056), 156-157, FIG. 4 (2000). Figure 2 illustrates switching elements 202 and 206, each of which introduces a 180 degree phase shift, that are positioned before and after an amplifier 204. The output signal from second switching element 206 are input to a low-pass filter 208 to provide an output voltage. The signals at the input to the first switching element 202 are presented in graphs 210 and 212. The output voltage of amplifier 204 is presented in graphs 214 and 216. The output of second switching element 206 is presented in graphs 218 and 220. The output of low pass filter 208 are presented in graphs 222 and 224. As is illustrated, the 1/f noise is upconverted to Fchop by output switching element 206. This noise is then out-of-band and filtered by low pass filter 208.

Although Figure 2 generally illustrates the effects of chopping in a low frequency circuit, the switching noise from switching elements 202 and 206 can be excessive in higher frequency systems. Consequently, a simple chopping circuit as illustrated in Figure 2 will not function in a pulsed UWB receiver as illustrated in Figure 1.

There are several frequencies in system 100 as illustrated in Figures 1A and 1B. The existing receiver is a sampled pulsed system operating at the pulse repetition frequency (PRF) sampling frequency. The receiver is pulsed at the PRF frequency. The fundamental parts to support a chopping system, i.e. a PRF timing generator CLK, are already present. The receiver is only actively receiving during a RX integration window. Outside of this time, receiver 104 is effectively off. The state of receiver 104 between PRF pulses can be modified. In particular, no signal path changes need to occur during the receive time when receiver 104 is active. The state of the receiver for each PRF pulse can be modified. If the receiver state change does not impact the wanted sampled signal, the state change can be used to change the RX response to the unwanted low frequency 1/f noise. The transient response to the received pulse should not be impacted as no state change occurs during the RX window.

In some cases, the received pulsed RF signal is 7.6GHz (500MHz bandwidth). The S/H output Doppler frequency is 0.2Hz to 166Hz. The Mixer IF 1/f noise frequency is <1KHz (1ms max period). This unwanted signal overlaps with the wanted Doppler information. For the purposes of this example a PRF of 1MHz is used.

In some embodiments, the 1/f noise is over sampled in an Integrator and sample and hold (S/H) at the PRF sampling rate, for example 1ms/1us = 1000 samples. The highest frequencies of the 1/f noise is oversample. Over a particular observation window (for example 5 second 0.2Hz), results in a large number of samples, for example there are 5s/1us = 5e6 samples. Consequently, there are a very large number of samples over the noise sampling window. As the 1/f noise of the Mixer IF is accurately sampled, we can move the frequency where the noise is located, to a higher frequency. The 1/f noise can be moved to a higher frequency than the wanted Doppler signals.

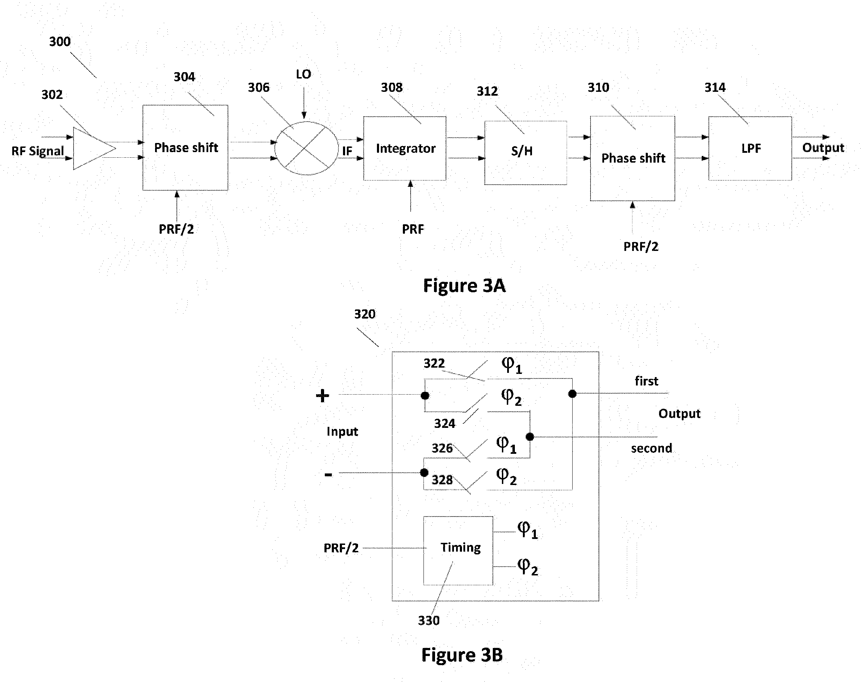

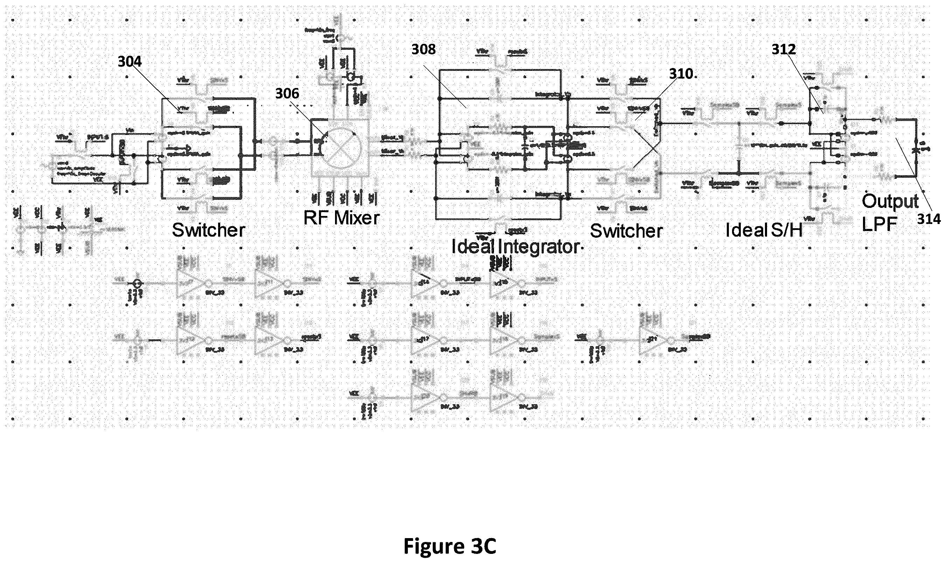

Figures 3A, 3B, and 3C illustrate an embodiment of a receiver 300 according to the present invention. As is illustrated in Figure 3A, receiver 300 receives an RF signal from an antenna in a low-noise amplifier and Balun circuit 302. As discussed above, the received pulsed RF signal can be at 7.6 GHz with a 500 MHz bandwidth. The output signal from Balun 302 is input to a first phase shift switching circuit (phase shift switch) 304, which is capable of introducing a 180° phase shift to the signal received from amplifier circuit 302. As is illustrated, phase shift circuit 304 is a switching circuit that is timed at half the periodic repetition frequency (PRF). As discussed above, receiver 300 is actively on or off according to the PRF. In some embodiments, PRF may be 1 MHz.

The output signal from phase shift switch 304 is input to an RF mixer 306 that mixes the signal with a low frequency LO to down-convert the signal to an intermediate frequency signal IF. As discussed above, the intermediate frequency signal IF is then input to an integrator 308. The output signal from integrator 308 may be input to a second phase shift switch 310, which operates the same as does first phase shift switch 304. However, in Figure 3A, the output signal from integrator 308 is input to sample and hold 312 and then input to second phase shift switch 310. Sample and hold circuit 312, in some embodiments, outputs a Doppler frequency in the range of 0.2Hz to 166 Hz. The output signal from sample and hold 312 is input to a low pass filter 314, which provides a final output signal. As is illustrated in Figure 3A, integrator 308 is gated at the PRF so that receiver 300 is not activated at all times.

Figure 3B illustrates an embodiment of phase shift 320, which can be used as phase shift switch 304 or phase shift switch 310. As is illustrated in Figure 3B, a positive input signal is input to switches 322 and 324 and a negative input signal is input to switches 326 and 328. Switch 322 is coupled to a first output while switch 324 is output to a second output. Switch 324 is coupled to a second output and switch 326 is output to the second output. Switches 322 and 326 are controlled by a timing signal ϕ₁ while switches 324 and 328 are control by a timing signal ϕ₂.

Timing circuit 330 receives the PRF/2 signal and generates the control timing signals ϕ₁ and ϕ₂.

Consequently, switches 322 and 326 can be engaged and switches 324 and 328 disengaged to provide a 0° phase shift. Switches 322 and 326 can be disengaged and switches 324 and 328 engaged to provide a 180° phase shift. In Figure 3A, phase shift switch 304 and phase shift switch 310 provide the same phase shift.

Figure 3C illustrates a conceptual layout of receiver 300 as illustrated in Figure 3A. As is illustrated, the signal is input to a phase shift switch 304. The output from phase shift switch 304 is input to RF mixer 306. The output from the RF mixer 306 is input to integrator 308. The output of integrator 308 is input to another phase shift switch 310. The output of the second phase shift switch 310 is input to a sample/hold circuit 312. The output of the S/H circuit 312 is then input to output low-pass filter 314.

In some embodiments of the present invention, as illustrated in Figures 3A, 3B, and 3C, the output noise of the system is measured over a long period of time (e.g., 5 sec) to resolve a 0.2Hz IF doppler signal. The level 1/f noise detected over this time is significant, particularly at very low frequencies. The pulse doppler radar system has a Periodic Repetition Frequency (PRF) frequency that is used to turn the receiver on and off. This signal can be used as a frequency input to invert the signal path of the mixer and the IF integrator and sample/hold every PRF event. This effectively mixes up the 1/f noise close to DC to the PRF frequency, reducing the noise at low frequencies.

As shown in Figures 3A and 3B, the chopping loop is formed by phase shift switches 304 and 310 and is located directly in front of the mixer 306 (at RF) and after the integrator block 308. The chopping is possible in the RF system because receiver 300 is not always on. The signal path can be inverted twice during the off period and no switching event is amplified. No phase synchronization of the RF phase shift switching circuits 304 and 310 and the IF circuit are required, provided they have both settled by the time receiver 300 is actively on.

Figures 4A and 4B further illustrates the conventional receiver 104 as illustrated in Figure 1B.

Figure 4A illustrates the RF to IF down conversion portion of receiver 100 while Figure 4B illustrates the IF to S/H output portion of receiver 100. As illustrated in Figure 4A, an RF input signal 402 is input to low-noise amplifier with a balun (LNA+Balun) 120. The input signal 402 may have a noise band-width (noise BW) around the frequency LO of greater than 500 MHz.

The output signal from LNA+Balun 120 is input to RF mixer 122, where it is mixed with a signal LO to down convert the signal to an intermediate frequency (IF). The IF signal 404 has a noise BW around DC equal to or greater than about 250 MHz. As shown in Figure 4B, the IF signal 404 is then input to an integrator 124 and then sample and hold circuit 126 to produce S/H IF output 406. The noise bandwidth between 0.2 Hz and about 166 Hz.

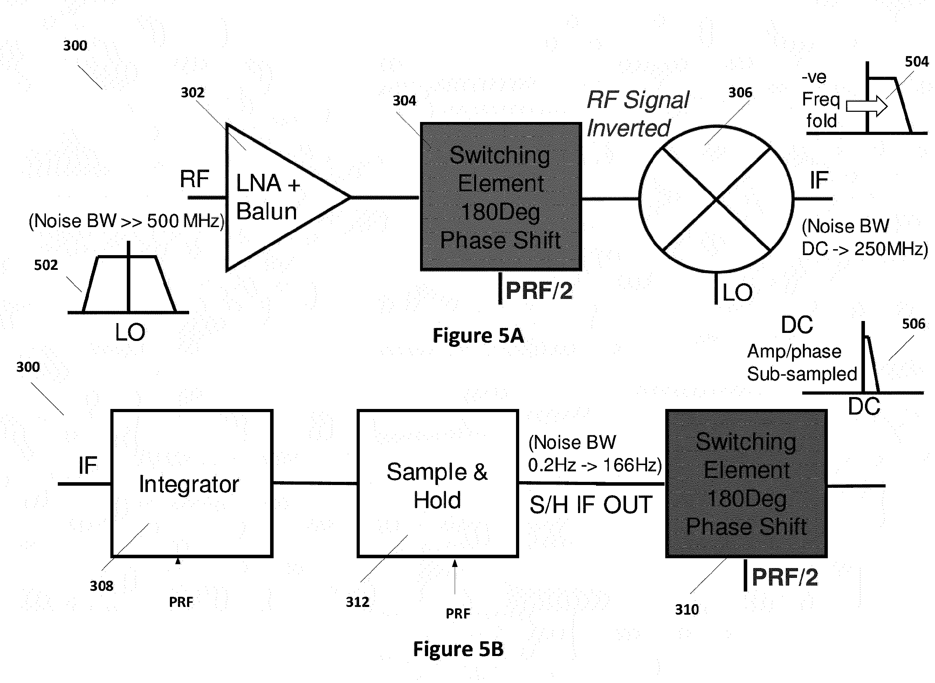

Figures 5A and 5B further illustrate another embodiment of receiver 300 according to some embodiments as illustrated in Figure 3A. Figure 5A illustrates the RF to IF down conversion portion of receiver 300 while Figure 5B illustrates the IF to S/H output resampling portion of receiver 300. As illustrated in Figure 5A, a first phase shift switch 304 that is switched at the frequency PRF/2, introducing a 180 degree phase shift, is inserted between the LNA+Balun element 302 and the RF mixer 306. A second phase shift switch 310, operated at frequency PRF/2, which also introduces a 180 degree phase shift, is inserted after the sample and hold element 312. As is illustrated in Figure 5A, the input RF signal 502 has a noise bandwidth of greater than 500 MHz. The IF signal 504 has a bandwidth of about 250MHz. The output signal 506 from phase shift switch 310 is also illustrated.

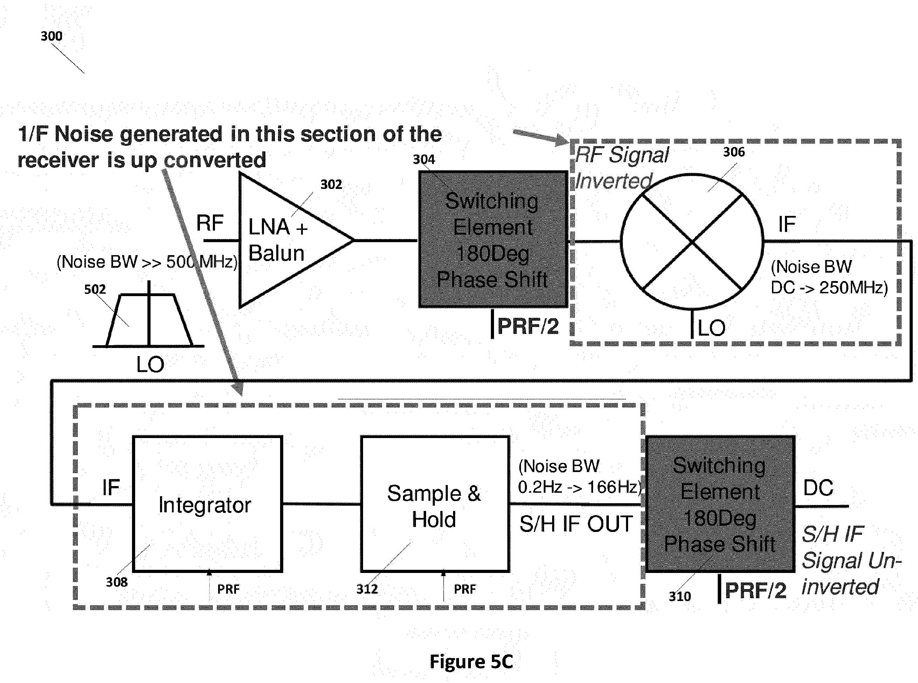

Figure 5C illustrates functionality of the resulting receiver 300 as illustrated in Figures 5A and 5B. As is illustrated in Figure 5C, the down converting signal down-converts the inverted RF signal. Further, 1/f noise generating in RF mixer 306, integrator 308, and sample and hold 308 is up converted by the operation of phase shift switches 304 and 310.

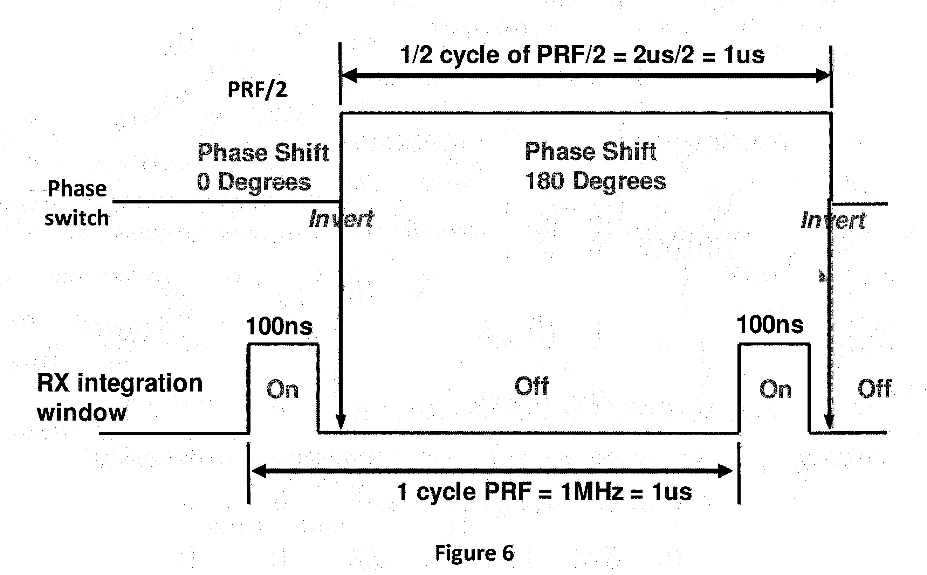

Figure 6 illustrates timing of the phase inversion signals in the system. The top trace indicates the 180 degree phase shifter control shifted at frequency PRF/2, or 500 kHz. The RX integration window is illustrated as a cycle of PRF. As is illustrated, the phase of the signal path is only switched when the integration window is off. As illustrated in Figure 6, phase shift switches are switched between 0 degree phase shift and 180 degree phase shift according to the switching signal PRF/2. Integrator 308 and sample and hold circuit 312 are controlled to be on according to the signal PRF. In particular, integrator 308 and sample and hold 312 are on for a period of time, for example 100 ns, on each cycle of PRF. With PRF being 1 MHz, PRF/2 is 500 kHz.

Consequently, phase shift switches 304 and 310 switch every microsecond. As illustrated in Figure 6, phase shift switches 304 and 310 are switched between phase shifts (0 degrees and 180 degrees) only when integrator 308 and sample and hold 312 are inactive (i.e. OFF).

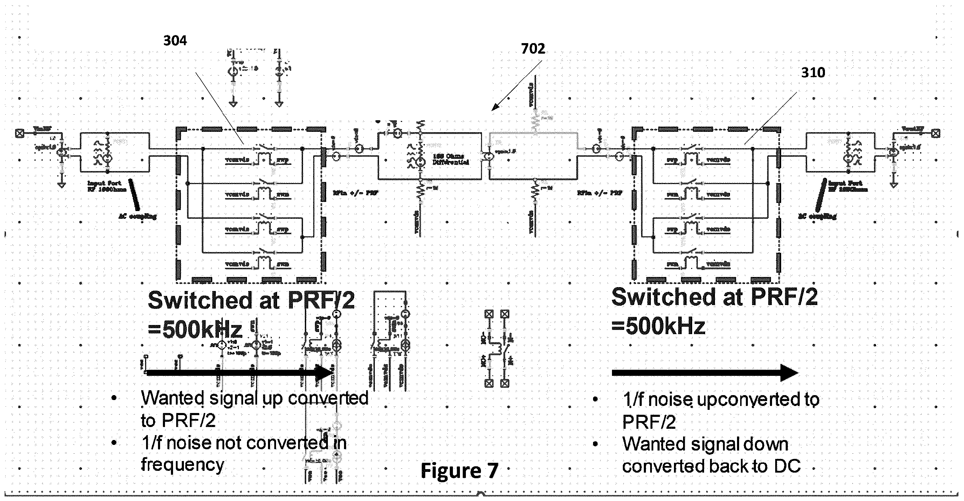

Figure 7 illustrates operation of receiver 300 as illustrated in Figures 5A, 5B, and 5C to eliminate the 1/f noise. As is illustrated, the first phase shift switch 304, which is switched at PRF/2, up converts the wanted signal to PRF/2, but the 1/f noise is not converted in frequency by this action. As discussed above, the 1/f noise is primarily generated in circuits that follow the first phase shift switch 304, circuit 702. Circuit 702 can include RF mixer 306, integrator 308, and S/H 312 or may only include integrator 308 and S/H 312. In the second phase shift switch 310, again switched at PRF/2, the 1/f noise that is generated in RF mixer 306, integrator 308, and sample and hold 312 is upconverted to PRF/2, but the wanted signal, which has been switched through both of phase shift switches 304 and 310, is down converted back to DC. Consequently, low-pass filter 314 can remove the 1/f noise while retaining the wanted signals.

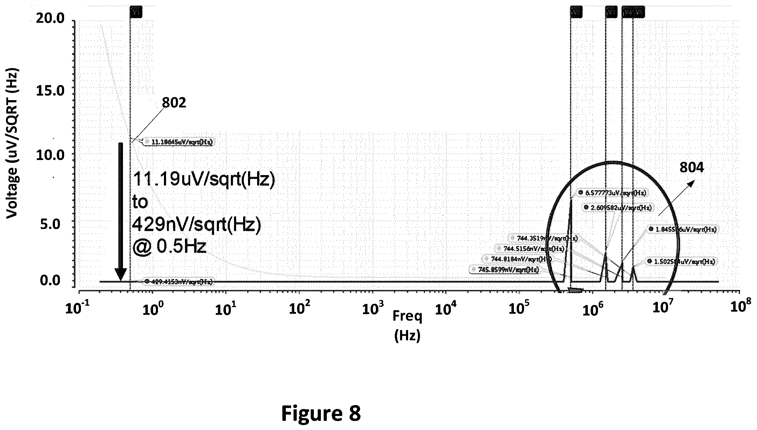

Figure 8 illustrates the idealized noise up conversion to PRF/2 output noise compared to the original linear noise file. Figure 8 illustrates the voltage signal as a function of frequency at the output of phase shift switch 310 and the voltage signal as a function of frequency of the noise signal from RF mixer 306. On the left is indicated the linear output noise 802 from mixer IF noise simulation, which has the 1/f noise characteristic. In particular, the linear output noise 802 at 0.5Hz is 11.19 µV t/sqrt(Hz) while the chopped noise amounts only to 426 nV/sqrt(Hz) at the same frequency. On the right is the large signal output noise 804 resulting from up conversion to the PRF/2 frequency (e.g. 500kHz), resulting in signals at PRF/2 (500 kHz), 3*PRF/2 (1.5 MHz), 5*PRF/2 (2.5 MHz), and 7*PRF/2 (3.5 MHz). As is illustrates, the upconverted output noise 804 can be removed by low pass filter 314.

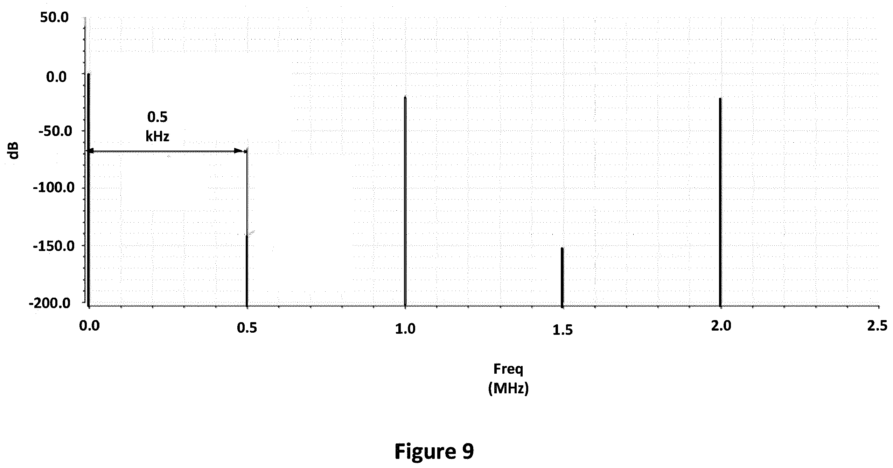

Figure 9 illustrates an idealized noise up periodic AC (PAC) voltage gain input to output. The circuit has low interference levels (IL) at the wanted frequency. The small signal has not been up converted to PRF/2. As is illustrated, the voltage gain at 0.2Hz is -4mdB. At 0.5 kHz, the gain is -141.365 db. Voltage gains at every 0.5 dB are illustrated.

Consequently, an idealized circuit as illustrated in Figure 4 above shows the up conversion of the 1/f noise to the PRF/2 and its odd harmonics. This matches the theory and expectation. The small signal gain of the wanted signal is preserved through the system, although in some measurements the amplification may be reduced. The small signal is up converted and then back down converted. The net frequency conversion resulting from the switching networks is 0.

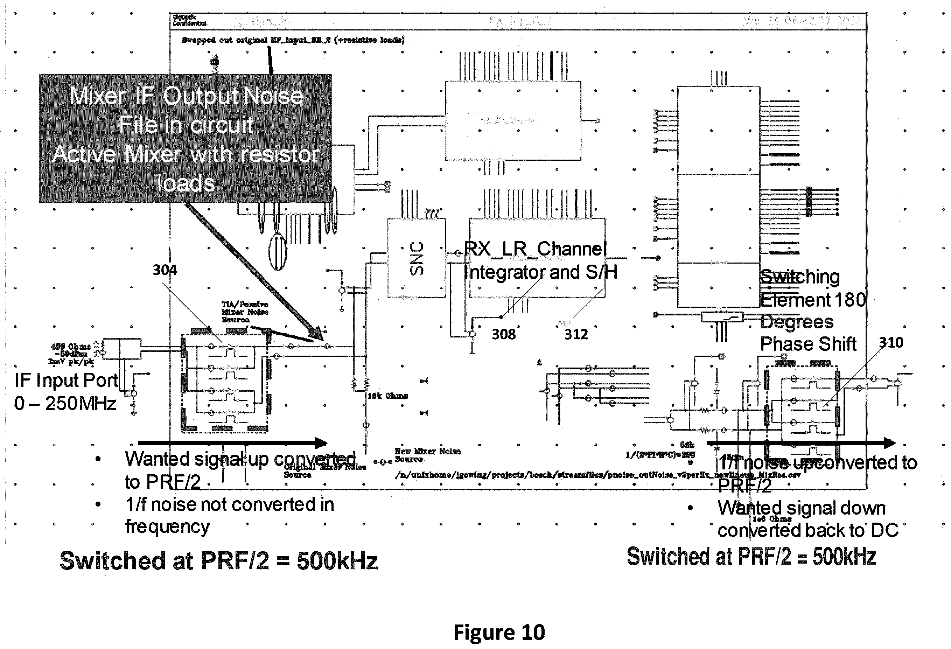

Figure 10 illustrates an example where idealized switching circuits is implemented around IF circuitry (integrator 308 and S/H circuit 312). In this example, first phase shift switch 304 receives the IF signal from RF mixer 306, instead of being placed before RF mixer 306. Figure 10 illustrates the IF input port and the first phase shift switch 304 with 180 degrees of phase shift. The wanted signal is up-converted to PRF/2 while the 1/f noise is not yet added to the signal. The output of first phase shift switch 304 includes the mixer IF output noise, with active mixer with resistive loads. The second phase shift switch 310 provides another 180 degree phase shift, where the 1/f noise is upconverted to PRF/2 while the wanted signal is down converted back to DC. The mixer IF output noise is also illustrated with resistive loads. Several secondary noise sources are also illustrated, including a second broadband input noise source to meet output noise specification.

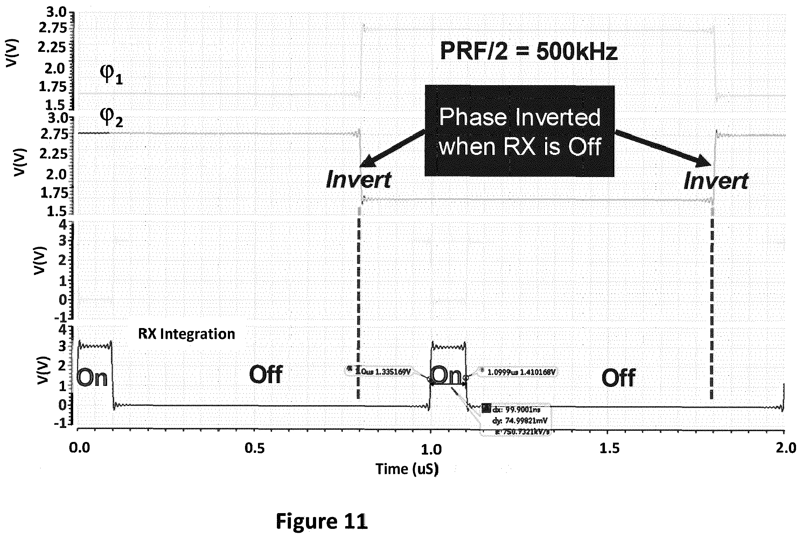

Figure 11 illustrates timing in an idealized switching circuit used for phase shift switch 304 and phase shift switch 310 placed around the integrator 308 and S/H circuitries 312. In this example, the RX integration is switched at PRF while the phase shift switches 304 and 310 are switched at PRF/2. The switching signals ϕ₁ and ϕ₂ for controlling phase shift switches 304 and 310 as is illustrated in Figure 3B are illustrated. As is illustrated, the phase inversions from the phase shift switches 304 and 310 occurs when the integrator 308 and S/H circuits 312 are in an off mode so that no switching noise is generated.

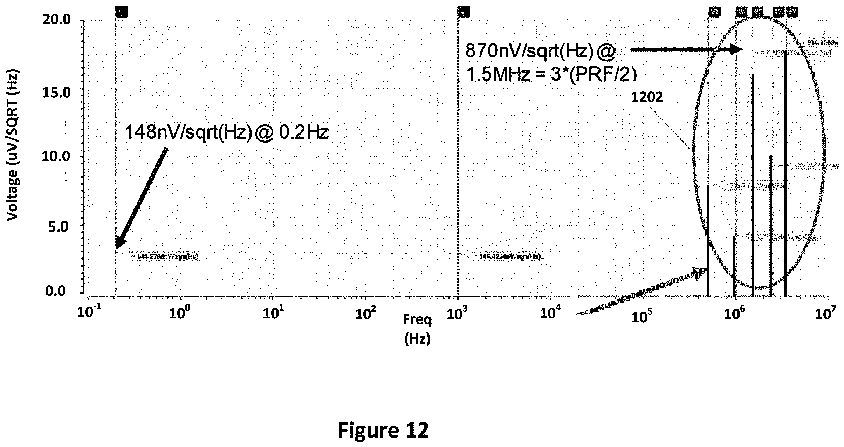

Figure 12 illustrates the output noise from the S/H in nV/sqrt(Hz) with idealized phase shift switches 304 and 310 are positioned around the integrator 308 and S/H circuit 312 as is illustrated in Figure 11. As illustrated, the large signal output noise 1202 is up converted to PRF/2, 3*PRF/2, 5*PRF/2, and 7*PRF/2. The noise characteristics differ from the idealized simulation discussed above because there is more noise at the higher order harmonics.

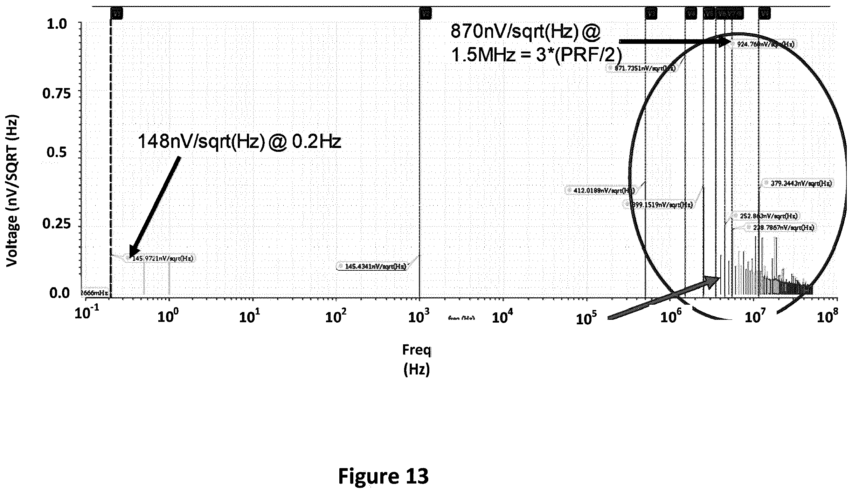

Figure 13 illustrates the output noise from the S/H circuit 312 in (nV/sqrt(Hz)) illustrated in Figure 12 with more resolution. The idealized phase shift switching circuits 304 and 310 are positioned around integrator 308 and S/H circuits 312, as is illustrated in Figure 11. The scan is between 0.2 Hz and 50 MHz in 500 kHz steps. The large signal output noise 1202 is up converted to the PRF/2, 3*PRF/2, 5*PRF/2, and 7*PRF/2. The trace illustrated in Figure 13 also shows more noise at the higher order harmonics than that illustrated in the idealized simulations.

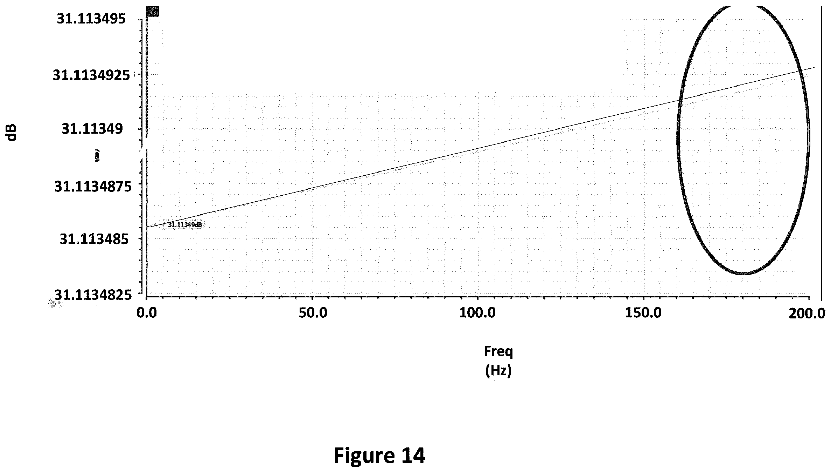

Figure 14 illustrates a small signal PAC Vgain dB20 input to output at 0.2Hz - 200Hz IF input with idealized phase shift switching circuits 304 and 310 positioned around the integrator 308 and S/H circuits 312. The wanted small signal voltage gain is shown as about 31 dB.

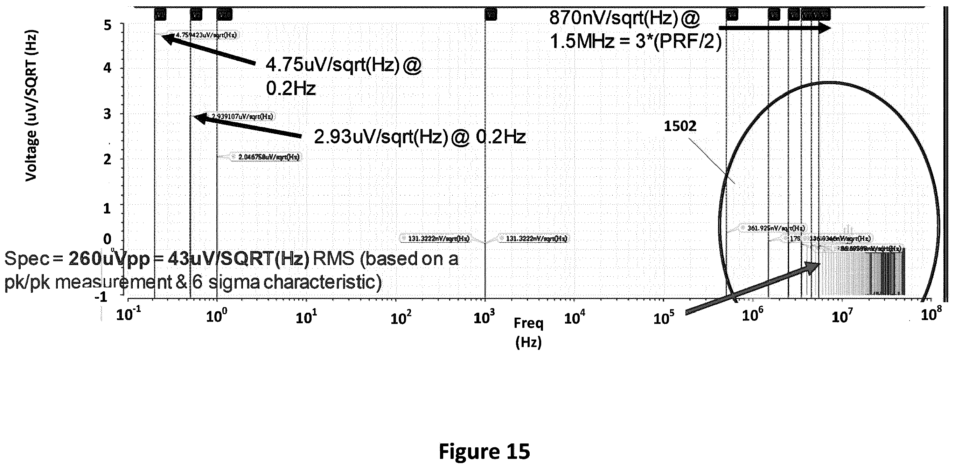

Figure 15 illustrates the output noise 1502 from the S/H (in nV/sqrt(Hz)) with more resolution.

This has an idealized input with realized output switching circuits around the integrator, but not the S/H. The scan is between 0.2Hz to 50 MHz in 500 kHz steps. This reflects an ideal input switching circuit used. The realized output switching circuit between the integrator and S/H noise may also be present at higher harmonics. As discussed before, the large signal output noise is up-converted to PRF/2, 3*PRF/2, 5*PRF/2, and 7*PRF/2. The noise is higher than with the idealized output switch at the S/H output, and the S/H noise is not canceled. There is more noise at the higher harmonics.

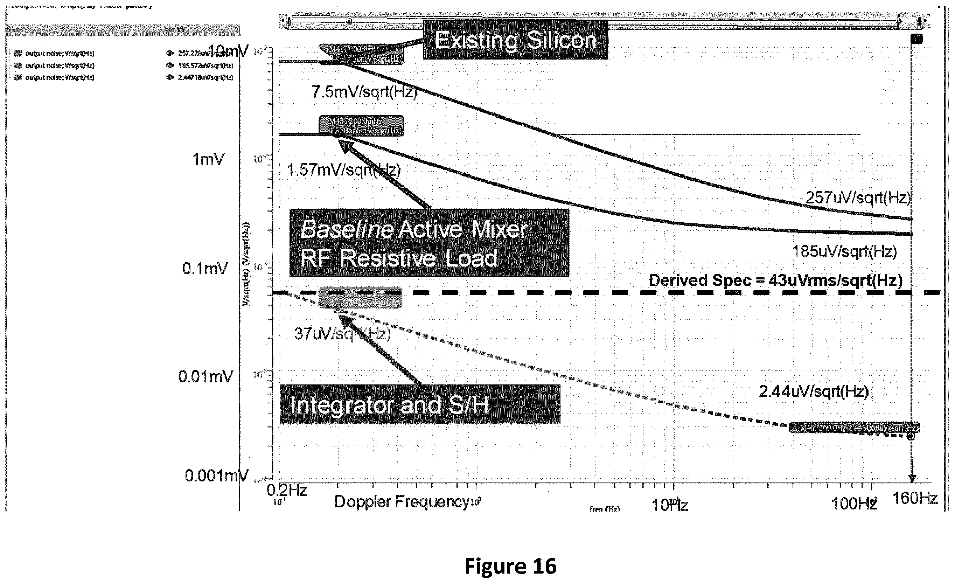

Figure 16 illustrates, with PRF=1MHz, noise with an S/H gain of 3 and integration window of 100ns. Existing silicon, baseline active mixer, and integrator and S/H noise levels are illustrated. In some situations, the Integrator 308 and S/H aliases 312 noise from higher frequencies into the low frequency passband. This is due to the PRF sub sampling the 250MHz IF BW. The phase inversion circuit up converts this noise to PRF/2 and its harmonics. There are two noise conversion mechanisms operating at the same time. It is not yet understood how that will interact with the noise down converted by the mixer to the IF. The CW concepts of NF are more difficult to apply to the system. The Integrator 308 and S/H 312 has been evaluated stand alone for 1/f noise improvement at 0.2Hz. It should be verified if there is an improvement for the whole RX system.

The above detailed description is provided to illustrate specific embodiments of the present invention and is not intended to be limiting. Numerous variations and modifications within the scope of the present invention are possible. The present invention is set forth in the following claims.

## Claims

1. A UWB receiver, comprising:
a down-conversion mixer coupled to the first switch and providing an IF signal;
an integrator that receives the IF signal, the integrator being switched on and off at a periodic repetition frequency (PRF);
a sample and hold circuit coupled to the integrator;
a first phase switch that is switched at PRF/2 coupled to receive a signal before the integrator;
a second phase switch coupled to the sample and hold circuit, the second switch also being switched at PRF/2; and
a low-pass filter coupled to the second switch, wherein 1/f noise is filtered out by the low-pass filter.

2. The receiver of claim 1, wherein the first switch is coupled to provide a signal to the down-conversion mixer.

3. The receiver of claim 1, wherein the first switch is coupled to receive the IF signal from the down-conversion mixer and provide a signal to the integrator.

4. The receiver of claim 1, wherein the first phase switch and the second phase switch switch between a phase shift of 0 degrees and a phase shift of 180 degrees.

5. The receiver of claim 1, wherein the first phase switch and the second phase switch switch between phases at a time when the integrator and the sample and hold circuit are not active.

6. The receiver of claim 1, wherein 1/f noise from the integrator and the sample and hold circuit are up-converted by the operation of the first phase switch and the second phase switch.

7. The receiver of claim 6, wherein the 1/f noise is up-converted by odd harmonics of PRF/2.

8. A method of operating a ultra-wide band (UWB) receiver, comprising:
receiving a pulsed RF signal;
down converting the RF to an intermediate frequency (IF) signal in an RF mixer, the IF signal being close to DC;
integrating the IF signal in an integrator, the integrator being switched on and off at a periodic repetition frequency (PRF);
sampling the integrated IF signal in a sample and hold circuit coupled to the integrator;
chopping signals with a first phase switch that is switched at PRF/2 coupled to receive a signal before the integrator and a second phase switch coupled to the sample and hold circuit, the second switch also being switched at PRF/2; and
removing the 1/f noise with a low-pass filter coupled to the second switch.

9. The method of claim 8, wherein the first switch is coupled to provide a signal to the down-conversion mixer.

10. The method of claim 8, wherein the first switch is coupled to receive the IF signal from the down-conversion mixer and provide a signal to the integrator.

11. The method of claim 8, wherein the first phase switch and the second phase switch switch between a phase shift of 0 degrees and a phase shift of 180 degrees.

12. The method of claim 8, wherein the first phase switch and the second phase switch switch between phases at a time when the integrator and the sample and hold circuit are not active.

13. The method of claim 8, wherein 1/f noise from the integrator and the sample and hold circuit are up-converted by the operation of the first phase switch and the second phase switch.

14. The method of claim 8, wherein the 1/f noise is up-converted by odd harmonics of PRF/2.
